# EUROPEAN PATENT APPLICATION

(11) **EP 1 870 930 A2**
(43) Date of publication of application: **26.12.2007**
(21) Application number: 07011061.4
(22) Date of filing: 05.06.2007
(51) Int. Cl.: H01L 21/762

(54) **Method of producing bonded wafer**

(30) Priority: 23.06.2006 JP 2006174035
(71) Applicant: SUMCO Corporation, Tokyo 105-8634 (JP)
(72) Inventor: Nishihata, Hideki, Minato-ku Tokyo 105-8634 (JP); Morimoto, Nobuyuki, Minato-ku Tokyo 105-8634 (JP); Endo, Akihiko, Minato-ku Tokyo 105-8634 (JP)
(74) Representative: Röthinger, Rainer

(57) **Abstract**

There is provided a method of producing a bonded wafer by bonding two silicon wafers for active layer and support layer to each other and then thinning the wafer for active layer, in which nitrogen ions are implanted from the surface of the wafer for active layer to form a nitride layer in the interior of the wafer for active layer before the bonding.

## Description

### BACKGROUND OF THE INVENTION

### 1. Field of the Invention

This invention relates to a method of producing a bonded wafer, and particularly it lies in that the occurrence of voids or blisters feared after the bonding and after the thinning is effectively prevented by forming a nitride layer (Si₃N₄ layer) on a surface of a wafer for an active layer or in an interior thereof to enhance a stiffness of the wafer for the active layer.

### 2. Description of Related Art

As a general method of producing a bonded wafer, there are known a method wherein a silicon wafer provided with an oxide film (insulating film) is bonded to another silicon wafer and the bonded silicon wafer is ground and polished to form SOI layer (grinding-polishing method), and a method wherein ions of hydrogen, a noble gas or the like are implanted into an interior of a silicon wafer for SOI layer (wafer for active layer) to form an ion implanted layer and bonded to a silicon wafer for a support layer and then exfoliated at the ion implanted layer through a heat treatment to form SOI layer (smart cut method).

Particularly, the smart cut method has a merit that the portion of the wafer exfoliated after the bonding can be recycled as a wafer, which is different from the conventional bonding technique. Since it is possible to use one wafer (wafer for the active layer) in the bonded wafer plural times by such a recycling, the material cost can be largely reduced, but also the wafer produced by the smart cut method is excellent in the uniformity of film thickness, so that the smart cut method is noticed as a production method with future potential.

Also, there is known a method wherein the wafer for active layer and the wafer for support layer are bonded without forming an oxide film as an insulating layer on the surfaces of these wafers and the wafer for active layer is ground and polished to form an active layer (direct bonding method). This directly bonded wafer has a feature that the design technology for the conventional bulk wafer without bonding can be applied as it is, and is expected in applications for high performances and low power consumption.

When the bonded wafer is prepared by the conventional techniques, defects such as voids or blisters are generated at the bonded interface. As the cause on the occurrence of these defects, there are considered particles or organic substance existing in the interface, gasification of hydrogen or noble gas ions implanted into the interior of the wafer for exfoliation at the bonded interface in the process of film-thinning through exfoliation, and so on.

It is known that the voids or blisters are frequently generated as the thickness of the insulating film existing between the two silicon wafers becomes thin, which will come into a serious problem in the production of bonded wafers having the thinned insulating layer or having no insulating layer. That is, it is considered that when the insulating film has a certain level of thickness, gas produced by the exfoliation heat treatment can be entrapped into the buried oxide film (insulating layer), while as the insulating layer becomes thin, the volume of the gas to be entrapped decreases and a part of the gas produced in the exfoliation heat treatment is not entrapped and causes the voids or blisters.

As a countermeasure for such a problem, JP-A-2004-259970 proposes a method wherein the occurrence of voids or blisters is suppressed by adjusting the thickness of the active layer before the thinning in accordance with the thickness of the insulating layer to enhance the stiffness of the active layer, concretely by thickening the thickness of the active layer before the film-thinning when the thickness of the insulating layer is made thin. However, during the progress in the thinning of SOI layer, the method of thickening the thickness of the active layer at the midway production step for improving the stiffness has a demerit that the thinning at the subsequent step takes a lot of labor and fears the deterioration of the quality.

### SUMMARY OF THE INVENTION

In view of the above situation, the invention is to propose a novel method of producing a bonded wafer in which the occurrence of voids or blisters can be effectively prevented by introducing a new stiffness providing means into the active layer before the film-thinning instead of the film-thickening without requiring the thickening of the thickness in the active layer before the film-thinning even if the thickness of the insulating layer is made thin.

The inventors have made various studies in order to achieve the above object and found out that a nitride layer is formed in a silicon wafer to enhance the stiffness therearound, and hence the stiffness equal to that in the film-thickening can be obtained by properly forming the nitride layer in the active layer even if the active layer is thin, and as a result, the invention has been accomplished.

The construction of the invention is as follows:
1. A method of producing a bonded wafer by bonding two silicon wafers for active layer and support layer to each other and then thinning the wafer for active layer, in which nitrogen ions are implanted from the surface of the wafer for active layer to form a nitride layer in the interior of the wafer for active layer before the bonding.

2. A method of producing a bonded wafer by bonding two silicon wafers for active layer and support layer to each other and then thinning the wafer for active layer, in which the wafer for active layer is subjected to a nitriding heat treatment to form a nitride layer on the surface of the wafer for active layer before the bonding.

3. A method of producing a bonded wafer according to the item 1 or 2, wherein the nitride layer has a thickness of 5-200 nm.

4. A method of producing a bonded wafer according to the item 1 or 2, wherein the thinning is a treatment of grinding and polishing a face of the wafer for active layer opposite to the bonding face thereof.

5. A method of producing a bonded wafer according to the item 1 or 2, wherein the thinning is an exfoliation treatment bounding an ion implanted layer of hydrogen or noble ions previously formed on the wafer for active layer.

6. A method of producing a bonded wafer according to the item 1 or 2, wherein at least one of the wafer for active layer and the wafer for support layer has an oxide film on its surface.

7. A method of producing a bonded wafer according to the item 6, wherein the oxide film formed on the surface of at least one of the wafer for active layer and the wafer for support layer has a thickness in total of not more than 50 nm.

8. A method of producing a bonded wafer according to the item 1 or 2, wherein an oxide film as an insulating layer is not existent on any surfaces of the wafer for active layer and the wafer for support layer.

9. A method of producing a bonded wafer according to the item 1 or 2, wherein the bonding process is a plasma bonding process.

According to the invention, the stiffness of the active layer can be made high effectively, so that even if the insulating layer is made thin, it is not necessary to thicken the thickness of the active layer before the thinning, and hence the subsequent thinning process is easy but also the deterioration of the quality is not caused.

### BRIEF DESCRIPTION OF THE DRAWINGS

FIG. 1 is a flow chart showing production steps of a bonded wafer through a smart cut method;
FIG. 2 is a schematic view illustrating an example of forming a nitride layer through an ion implantation;
FIG. 3 is a schematic view illustrating an example of forming a nitride layer through a nitriding heat treatment; and
FIG. 4 is a schematic view illustrating another example of forming a nitride layer through a nitriding heat treatment.

### DESCRIPTION OF THE PREFERRED EMBODIMENTS

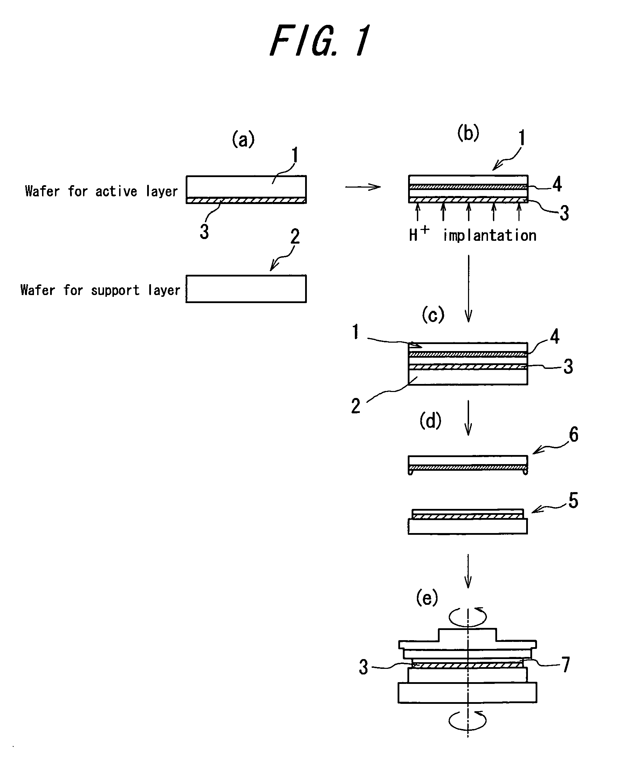

The invention will be described concretely below. In FIG. 1 is shown production steps of a bonded wafer taking a smart cut method as a typical production example of a bonded wafer.

After a wafer 1 for active layer and a wafer 2 for support layer are previously provided, at least one face of the wafer 1 for active layer is first subjected to a thermal oxidation to form an insulating film 3 (silicon oxide film) on the surface thereof (FIG. 1 (a)), ions of a light element such as hydrogen, helium or the like are implanted to a predetermined depth position of the wafer 1 for active layer to form an ion implanted layer 4 (FIG. 1(b)), and thereafter the wafer 1 for active layer is bonded to the wafer 2 for support layer (FIG. 1(c)), which is then separated into SOI substrate 5 and a remnant 6 by exfoliating at the ion implanted layer 4 through a heat treatment (usually about 400-600°C) (FIG. 1(d)). The separated remnant 6 is recycled as a wafer for active layer, while the SOI substrate 5 is applied, for example, to a polishing step, at where an active layer 7 is thinned to obtain a final product.

In the invention, a nitride layer is formed in the active layer (SOI layer) in order to increase the stiffness (hardness) of the wafer for active layer. In this case, if the oxide film is existent on the surface of the wafer for active layer, the nitride layer is formed just beneath the oxide film in the wafer for active layer, or if the oxide film is not existent in the wafer for active layer, the nitride layer is formed in the extreme vicinity of the surface of the wafer for active layer.

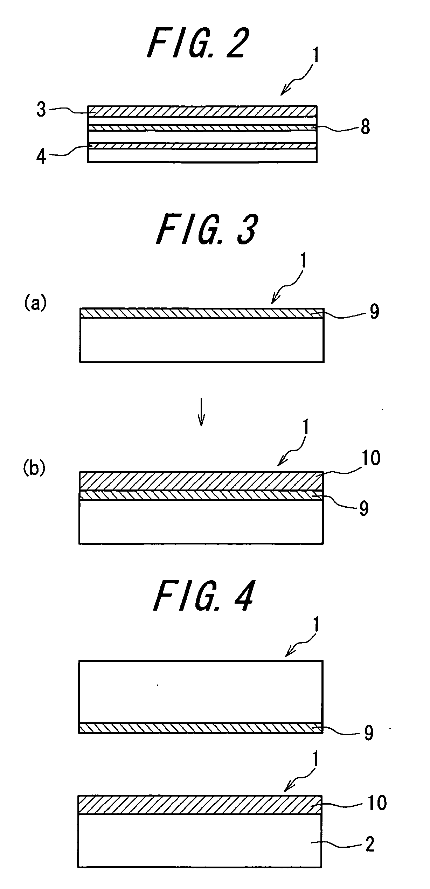

For example, in case of using a method of introducing nitrogen ions through ion implantation, when the oxide film is existent in the wafer for active layer, as shown in FIG. 2, nitrogen ions are introduced so that a peak of nitrogen ion concentration implanted comes to any position below the oxide film 3 in the wafer 1 for active layer and shallower than the ion implanted layer 4 of hydrogen ions or the like for exfoliation, whereby a nitride layer 8 is formed. On the other hand, when the oxide film is not existent in the wafer for active layer, the nitride layer is formed by introducing nitrogen ions so that a peak of nitrogen ion concentration implanted comes to any position beneath the surface of the wafer for active layer and shallower than the ion implanted layer 4 of hydrogen ions or the like for exfoliation.

When the nitride layer is formed by the above ion implantation process, it is preferable that the thickness of the nitride layer is about 5-200 nm. When the thickness of the nitride layer is less than 5 nm, the satisfactory increase of the stiffness is not attained, while when it exceeds 200 nm, a non-nitrided active region does not remain after the subsequent thinning treatment. Also, the forming position of the nitride layer may be any region as far as it is shallower than the ion implanted layer for exfoliation irrespectively of the presence or absence of the oxide film, but us preferable just beneath the oxide film.

In order to form such a nitride layer, the implantation conditions of nitrogen ions may be adjusted to the following ranges.
Acceleration energy: 1-80 keV
Implantation dose: 1.0x10¹⁵-1.0x10¹⁷/cm²
More preferably, the acceleration energy is 3 keV and the implantation dose is 2.0x10¹⁵/cm², whereby the nitride layer having a thickness of about 10 nm can be formed in the vicinity of the surface of the wafer for active layer.

In case of using a method of forming a nitride layer by a nitriding heat treatment, when the oxide film is required in the wafer for active layer, a nitride layer 9 is first formed on the surface of the wafer 1 for active layer as shown in FIG. 3(a), and then an oxide film 10 is formed on a surface layer portion of the nitride layer through an oxidation heat treatment, a chemical vapor deposition process or the like as shown in FIG. 3(b). Thus, the nitride layer 9 is formed just beneath the oxide film 10.

Alternatively, as shown in FIG. 4(a), the oxide film 10 is formed on the surface of the wafer 2 for support layer, while the nitride layer 9 is formed on the surface of the wafer 1 for active layer, and then these wafers may be bonded to each other.

On the other hand, when the oxide film is not required in the wafer for active layer, it is enough to form a nitride layer having a desired thickness by subjecting the surface of the wafer for active layer to the nitriding heat treatment.

Even in this case, the thickness of the nitride layer is preferable to be about 5-200 nm.

In order to form such a nitride layer, the conditions of the nitriding heat treatment are preferable as follows.
Treating atmosphere: dichlorosilane + ammonia atmosphere
Treating temperature: 750-800°C
Treating time: 10-20 minutes

In the invention, if it is intended to form the oxide film, at least one of the wafer for active layer and the wafer for support layer may be subjected to the oxidation heat treatment. In this case, the thickness of the oxide film is preferable to be not more than 150 nm in total.

In the invention, the bonding method is not particularly limited, but any of the conventionally known atmospheric bonding method, reduced-pressure bonding method and the like may be adapted advantageously, but a plasma bonding method is particularly preferable.

### Example 1

After two wafers having a diameter of 300 mm are provided, an oxide film having a thickness of 50 nm is formed on a surface of a wafer for active layer by an oxidation heat treatment. Then, nitrogen ions are implanted from the surface of the wafer for active layer provided with the oxide film under conditions of acceleration energy: 23 keV and implantation dose: 2.0x10¹⁵/cm² so that a peak of nitrogen ion concentration comes to a depth position of 60 nm from the surface of the wafer, whereby a nitride layer having a thickness of 10 nm is formed.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer provided with the oxide film, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Example 2

After two wafers having a diameter of 300 mm are provided, an oxide film having a thickness of 50 nm is formed on a surface of a wafer for active layer by an oxidation heat treatment. Then, nitrogen ions are implanted from the surface of the wafer for active layer provided with the oxide film under conditions of acceleration energy: 80 keV and implantation dose: 2.0x10¹⁵/cm² so that a peak of nitrogen ion concentration comes to a depth position of 200 nm from the surface of the wafer, whereby a nitride layer having a thickness of 10 nm is formed.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer provided with the oxide film, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Example 3

After two wafers having a diameter of 300 mm are provided, a nitride layer having a thickness of 10 nm is formed on a surface of a wafer for active layer by a nitriding heat treatment. Then, an oxide film having a thickness of 50 nm is formed on the surface of the wafer for active layer provided with the nitride layer through a chemical vapor deposition process. Thus, the wafer for active layer is at a state of forming the nitride layer of 10 nm in thickness just beneath the oxide film.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Example 4

After two wafers having a diameter of 300 mm are provided, nitrogen ions are implanted from a surface of a wafer for active layer under conditions of acceleration energy: 3 keV and implantation dose: 2.0x10¹⁵/cm² so that a peak of nitrogen ion concentration comes to a depth position of 10 nm from the surface of the wafer, whereby a nitride layer having a thickness of 10 nm is formed.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Example 5

After two wafers having a diameter of 300 mm are provided, nitrogen ions are implanted from a surface of a wafer for active layer under conditions of acceleration energy: 80 keV and implantation dose: 2.0x10¹⁵/cm² so that a peak of nitrogen ion concentration comes to a depth position of 200 nm from the surface of the wafer, whereby a nitride layer having a thickness of 10 nm is formed.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Example 6

After two wafers having a diameter of 300 mm are provided, a nitride layer having a thickness of 10 nm is formed on a surface of a wafer for active layer by a nitriding heat treatment.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Example 7

After two wafers having a diameter of 300 mm are provided, nitrogen ions are implanted from a surface of a wafer for active layer under conditions of acceleration energy: 3 keV and implantation dose: 2.0x10¹⁵/cm² so that a peak of nitrogen ion concentration comes to a depth position of 10 nm from the surface of the wafer, whereby a nitride layer having a thickness of 10 nm is formed.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the plasma bonding method, which is subjected to a heat treatment of 500°C to exfoliate at the exfoliation layer (ion implanted layer). After the exfoliation, the state of generating voids and blisters on the resulting SOI substrate is examined by an appearance inspection.

### Example 8

After two wafers having a diameter of 300 mm are provided, nitrogen ions are implanted from a surface of a wafer for active layer under conditions of acceleration energy: 80 keV and implantation dose: 1.0x10¹⁵/cm² so that a peak of nitrogen ion concentration comes to a depth position of 200 nm from the surface of the wafer, whereby a nitride layer having a thickness of 10 nm is formed.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the plasma bonding method, which is subjected to a heat treatment of 500°C to exfoliate at the exfoliation layer (ion implanted layer). After the exfoliation, the state of generating voids and blisters on the resulting SOI substrate is examined by an appearance inspection.

### Example 9

After two wafers having a diameter of 300 mm are provided, a nitride layer having a thickness of 10 nm is formed on a surface of a wafer for active layer by a nitriding heat treatment.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer for active layer, whereby an exfoliation layer is formed.

Thereafter, the wafer for active layer is bonded to another silicon wafer as a wafer for support layer by the plasma bonding method, which is subjected to a heat treatment of 500°C to exfoliate at the exfoliation layer (ion implanted layer). After the exfoliation, the state of generating voids and blisters on the resulting SOI substrate is examined by an appearance inspection.

### Comparative Example 1

After two wafers having a diameter of 300 mm are provided, an oxide film having a thickness of 150 nm is formed on a surface of a wafer for active layer by an oxidation heat treatment.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer provided with the oxide film, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Comparative Example 2

After two wafers having a diameter of 300 mm are provided, an oxide film having a thickness of 50 nm is formed on a surface of a wafer for active layer by an oxidation heat treatment.

Then, hydrogen ions are implanted under conditions of acceleration energy: 40 keV and implantation dose: 5.0x10¹⁶/cm² so that a peak of hydrogen ion concentration comes to a depth position of 400 nm from the surface of the wafer provided with the oxide film, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Comparative Example 3

After two wafers having a diameter of 300 mm are provided, hydrogen ions are implanted under conditions of acceleration energy: 40 keV and implantation dose: 5.0x10¹⁶/cm² so that a peak of hydrogen ion concentration comes to a depth position of 400 nm from the surface of the wafer provided with the oxide film, whereby an exfoliation layer is formed.

Thereafter, the wafer for active layer is bonded to another silicon wafer as a wafer for support layer by the usual bonding method (atmospheric bonding method), which is subjected to a heat treatment of 500°C to exfoliate at the exfoliation layer (ion implanted layer). After the exfoliation, the state of generating voids and blisters on the resulting SOI substrate is examined by an appearance inspection.

### Comparative Example 4

After two wafers having a diameter of 300 mm are provided, hydrogen ions are implanted under conditions of acceleration energy: 40 keV and implantation dose: 5.0x10¹⁶/cm² so that a peak of hydrogen ion concentration comes to a depth position of 400 nm from the surface of the wafer provided with the oxide film, whereby an exfoliation layer is formed.

Thereafter, the wafer for active layer is bonded to another silicon wafer as a wafer for support layer by the plasma bonding method, which is subjected to a heat treatment of 500°C to exfoliate at the exfoliation layer (ion implanted layer). After the exfoliation, the state of generating voids and blisters on the resulting SOI substrate is examined by an appearance inspection.

The results examined on the state of generating voids and blisters are shown in Table 1 with respect to Examples 1-9 and Comparative Examples 1-4. Moreover, the numerical value in this table is an average value of 100 samples on each example. Further, the evaluation is conducted as a relative ratio based on that a non-defective ratio of Comparative Example 1 having an oxide film thickness of 150 nm is 1.0.

**Table 1**

| Thickness of oxide film (bonding method) | Non-defective ratio (relative ratio to Comparative Example 1) | | | | |
|---|---|---|---|---|---|
| | No formation of nitride layer | Formation of nitride layer by nitrogen ion implantation | | | Formation of nitride layer by nitriding heat treatment |
| | | Implantation depth: 10nm | Implantation depth: 60nm | Implantation depth: 200nm | |
| 150 nm | 1.00 | - | - | - | - |
| (atmospheric bonding method) | (Comparative Example 1) | | | | |
| 50 nm | 0.50 | - | 0.95 | 0.92 | 0.89 |
| (atmospheric bonding method) | (Comparative Example 2) | | (Example 1) | (Example 2) | (Example 3) |
| 0 nm | 0.21 | 0.84 | - | 0.87 | 0.79 |
| (atmospheric bonding method) | (Comparative Example 3) | (Example 4) | | (Example 5) | (Example 6) |
| 0 nm | 0.75 | 0.93 | - | 0.92 | 0.90 |
| (plasma bonding method) | (Comparative Example 4) | (Example 7) | | (Example 8) | (Example 9) |

As seen from Table 1, the non-defective ratio in the conventional technique becomes 0.5 when the thickness of the oxide film is thinned from 150 nm to 50 nm and is 0.21 or decreases to about 1/5 when the oxide film is not formed, while according to the invention, even when the thickness of the oxide film is made thin, the occurrence of voids and blisters can be largely reduced without thickening the thickness of the active layer in the midway step of the production, and hence the non-defective ratio can be considerably improved.

## Claims

1. A method of producing a bonded wafer by bonding two silicon wafers for active layer and support layer to each other and then thinning the wafer for active layer, in which nitrogen ions are implanted from the surface of the wafer for active layer to form a nitride layer in the interior of the wafer for active layer before the bonding.

2. A method of producing a bonded wafer by bonding two silicon wafers for active layer and support layer to each other and then thinning the wafer for active layer, in which the wafer for active layer is subjected to a nitriding heat treatment to form a nitride layer on the surface of the wafer for active layer before the bonding.

3. A method of producing a bonded wafer according to claim 1 or 2, wherein the nitride layer has a thickness of 5-200 nm.

4. A method of producing a bonded wafer according to claim 1 or 2, wherein the thinning is a treatment of grinding and polishing a face of the wafer for active layer opposite to the bonding face thereof.

5. A method of producing a bonded wafer according to claim 1 or 2, wherein the thinning is an exfoliation treatment bounding an ion implanted layer of hydrogen or noble ions previously formed on the wafer for active layer.

6. A method of producing a bonded wafer according to claim 1 or 2, wherein at least one of the wafer for active layer and the wafer for support layer has an oxide film on its surface.

7. A method of producing a bonded wafer according to claim 6, wherein the oxide film formed on the surface of at least one of the wafer for active layer and the wafer for support layer has a thickness in total of not more than 50 nm.

8. A method of producing a bonded wafer according to claim 1 or 2, wherein an oxide film as an insulating layer is not existent on any surfaces of the wafer for active layer and the wafer for support layer.

9. A method of producing a bonded wafer according to claim 1 or 2, wherein the bonding process is a plasma bonding process.
